# EUROPEAN PATENT APPLICATION

(11) **EP 4 668 330 A1**
(43) Date of publication of application: **24.12.2025**
(21) Application number: 25182616.0
(22) Date of filing: 13.06.2025
(51) Int. Cl.: H01L 23/373, H01L 23/42, H01L 25/065

(54) **SEMICONDUCTOR DEVICE INCLUDING HYBRID DIAMOND THERMAL INTERPOSER AND METHOD OF MANUFACTURING THE SAME**

(30) Priority: 18.06.2024 US 202463661294 P; 20.03.2025 US 202519085797; 02.06.2025 KR 20250072409
(71) Applicant: Samsung Electronics Co., Ltd., Suwon-si, Gyeonggi-do 16677 (KR)
(72) Inventor: KIM, Patrick Guho, San Jose, CA, 95134 (US); YANG, Jin, San Jose, CA, 95134 (US); ESLAMPOUR, Hamid, San Jose, CA, 95134 (US); CHANG, Hochan, San Jose, CA, 95134 (US); KIM, WooPoung, San Jose, CA, 95134 (US)
(74) Representative: Kuhnen & Wacker Patent- und Rechtsanwaltsbüro PartG mbB

(57) **Abstract**

Semiconductor devices and methods of manufacturing the semiconductor devices are provided. For example, a semiconductor device (1A) may include: a substrate (20); an interposer (50) at least partially on a first surface of the substrate (20) that faces in a first direction; a first semiconductor chip (70) on a first surface of the interposer (50) that faces in the first direction; a second semiconductor chip (80) at least partially on the first surface of the interposer (50), the second semiconductor chip (80) spaced apart from the first semiconductor chip (70) in a second direction that crosses the first direction; a hybrid diamond thermal interposer (90) at least partially on a first surface of the first semiconductor chip (70) that faces in the first direction or at least partially on a first surface of the second semiconductor chip (80) that faces in the first direction, wherein the hybrid diamond thermal interposer (90) includes diamond particles (94) within a metal.

## Description

### BACKGROUND

### 1. Field

Embodiments of the present disclosure may relate to semiconductor devices, and more particularly to, for example, semiconductor devices including hybrid diamond thermal interposers.

### 2. Description of Related Art

Recently, there has been an industry demand for semiconductor devices to have a high number of inputs and outputs (I/O), high bandwidth, low latency, high power efficiency, small form factor (footprint), etc. Since integration of logic dies and high bandwidth memory (HBM) packages requires a large amount of power, there is an urgent need for thermal performance improvements for high performance advanced packages.

By improving thermal performance of semiconductor devices (e.g., high performance devices such as high performance advanced packages), the semiconductor devices may be efficiently cooled and a lifetime of a product may be increased.

### SUMMARY

Embodiments of the present disclosure may address the above problems and/or other problems.

According to some example embodiments of the present disclosure, semiconductor devices (e.g., semiconductor packages) may be provided that have improved thermal performance.

According to some example embodiments of the present disclosure, semiconductor devices (e.g., semiconductor packages) that include a hybrid diamond thermal interposer may be provided for high performance applications (e.g., network, artificial intelligence (AI), high performance computing (HPC), mobile, wearable, etc.), and may be configured as advanced packages.

According to some example embodiments of the present disclosure, semiconductor devices (e.g., semiconductor packages) may be provided that have improved thermal performance without sacrificing mechanical integrity of the semiconductor device.

According to some example embodiments of the present disclosure, a hybrid diamond thermal interposer with a high thermal conductive thermal interface material (TIM) may be provided, which can significantly improve thermal performance while enabling a semiconductor device (e.g., a semiconductor package) to have a high level of mechanical integrity (e.g., during thermal cycles).

According to some example embodiments of the present disclosure, semiconductor devices such as, for example, system-in-packages (SIPs), flip chip packages, advanced wafer-level and panel-level packages, and other high performance packages may be provided that require and have high thermal performance.

According to some example embodiments of the present disclosure, a semiconductor device may include: a substrate; an interposer at least partially on a first surface of the substrate that faces in a first direction; a first semiconductor chip at least partially on a first surface of the interposer that faces in the first direction; a second semiconductor chip at least partially on the first surface of the interposer, the second semiconductor chip spaced apart from the first semiconductor chip in a second direction that crosses the first direction; and a hybrid diamond thermal interposer at least partially on a first surface of the first semiconductor chip that faces in the first direction or at least partially on a first surface of the second semiconductor chip that faces in the first direction, wherein the hybrid diamond thermal interposer includes diamond particles within a matrix.

According to some example embodiments of the present disclosure, a semiconductor device may include: an interposer; a first semiconductor chip at least partially on a first surface of the interposer that faces in a first direction, wherein the first semiconductor chip is a logic chip; a second semiconductor chip at least partially on the first surface of the interposer, the second semiconductor chip spaced apart from the first semiconductor chip in a second direction that crosses the first direction, wherein the second semiconductor chip includes a high bandwidth memory (HBM); and a hybrid diamond thermal interposer at least partially on a first surface of the first semiconductor chip that faces in the first direction, wherein the hybrid diamond thermal interposer includes diamond particles within a metal.

According to some example embodiments of the present disclosure, a method of manufacturing a semiconductor device may include: providing an intermediate semiconductor device that includes: a substrate; an interposer at least partially on a first surface of the substrate that faces in a first direction; a first semiconductor chip at least partially on a first surface of the interposer that faces in the first direction; and a second semiconductor chip at least partially on the first surface of the interposer, the second semiconductor chip spaced apart from the first semiconductor chip in a second direction that crosses the first direction. The method may further include providing a hybrid diamond thermal interposer at least partially on a first surface of the first semiconductor chip that faces in the first direction or at least partially on a first surface of the second semiconductor chip that faces in the first direction, wherein the hybrid diamond thermal interposer includes diamond particles within a metal.

### BRIEF DESCRIPTION OF DRAWINGS

Example embodiments of the present disclosure will be more clearly understood from the following detailed description taken in conjunction with the accompanying drawings in which:
FIG. 1 illustrates a schematic magnified cross-sectional view of a hybrid diamond thermal interposer according to an example embodiment of the present disclosure;
FIG. 2A illustrates a schematic cross-sectional view of a semiconductor device according to an example embodiment of the present disclosure;
FIG. 2B illustrates a schematic magnified view of a part A of FIG. 2A according to an example embodiment of the present disclosure;
FIG. 3 illustrates a schematic cross-sectional view of a semiconductor device according to an example embodiment of the present disclosure;
FIG. 4 illustrates a schematic cross-sectional view of a semiconductor device according to an example embodiment of the present disclosure;
FIG. 5 illustrates a schematic cross-sectional view of a semiconductor device according to an example embodiment of the present disclosure;
FIG. 6A illustrates a schematic cross-sectional view of a semiconductor device according to an example embodiment of the present disclosure;
FIG. 6B illustrates a schematic cross-sectional view of a semiconductor device according to an example embodiment of the present disclosure;
FIG. 7 illustrates a schematic cross-sectional view of a semiconductor device according to an example embodiment of the present disclosure;
FIG. 8A illustrates a schematic cross-sectional view of a semiconductor device according to an example embodiment of the present disclosure;
FIG. 8B illustrates a schematic cross-sectional view of a semiconductor device according to an example embodiment of the present disclosure;
FIG. 9 illustrates a schematic cross-sectional view of a semiconductor device according to an example embodiment of the present disclosure;
FIG. 10 illustrates a schematic cross-sectional view of a semiconductor device according to an example embodiment of the present disclosure;
FIG. 11 illustrates a schematic cross-sectional view of a semiconductor device according to an example embodiment of the present disclosure;
FIG. 12 illustrates a flowchart for a method of manufacturing a semiconductor device according to example embodiments of the present disclosure;
FIG. 13 illustrates an intermediate semiconductor device formed in an operation of the method of FIG. 12, according to example embodiments of the present disclosure;
FIG. 14 illustrates an intermediate semiconductor device formed in an operation of the method of FIG. 12, according to example embodiments of the present disclosure;
FIG. 15 illustrates an intermediate semiconductor device formed in operations of the method of FIG. 12, according to example embodiments of the present disclosure;
FIG. 16 illustrates an intermediate semiconductor device formed in operations of the method of FIG. 12, according to example embodiments of the present disclosure; and
FIG. 17 illustrates a schematic plan view of first semiconductor chips and memory devices of a semiconductor device according to example embodiments of the present disclosure.

### DETAILED DESCRIPTION

Embodiments of the present disclosure described herein are example embodiments, and thus, the present disclosure is not limited thereto, and may be realized in various other forms. Each of the embodiments provided in the following description is not excluded from being associated with one or more features of another embodiment also provided herein or not provided herein but consistent with the present disclosure. For example, even if matters described in a specific example embodiment are not described in a different example embodiment, the matters may be understood as being related to or combined with the different example embodiment, unless otherwise mentioned in descriptions thereof.

It will be understood that when an element, component, layer, pattern, structure, region, or so on (hereinafter collectively "element") of a semiconductor device (or semiconductor package) is referred to as being "on," "connected to," or "coupled to" another element the semiconductor device, it can be directly on, connected to, or coupled to the other element or an intervening element(s) may be present. In contrast, when an element of a semiconductor device is referred to as being "directly on," "directly connected to," or "directly coupled to" another element of the semiconductor device, there are no intervening elements present. Like numerals refer to like elements throughout the present disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions here below, the "left" element and the "right" element may also be referred to as a "first" element or a "second" element, respectively, as long as their structural relationship is clearly understood in the context of the descriptions. Similarly, the terms a "lower" element and an "upper" element may be respectively referred to as a "first" element and a "second" element to distinguish the two elements.

It will be understood that, although the terms "first," "second," "third," "fourth," "fifth," "sixth," etc., may be used herein to describe various elements, these elements should not be limited by these terms. These terms are only used to distinguish one element from another element. Thus, a first element discussed below could be termed a second element without departing from the scope of the present disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" or "equal" is used to compare a dimension of two or more elements, the term may cover a "substantially same" or "substantially equal" dimension.

When a component is described as being "on" another component, the component may be "partially on" or "completely on" the other component. That is, the component may be "at least partially on" the other component.

It will be also understood that, when a method of manufacturing an apparatus or structure is described as including a plurality of steps or operations, a certain step or operation described as being performed later than another step or operation may be performed prior to or at the same time as the other step or operation unless the other step or operation is described as necessarily being performed prior to the step or operation. Further, the method may include additional steps or operations not mentioned in the description.

Many example embodiments are described herein with reference to cross-sectional views that are schematic illustrations of the embodiments (and intermediate structures). As such, variations from the shapes of the illustrations as a result of, for example, manufacturing techniques and/or tolerances are to be expected. Thus, the embodiments should not be construed as limited to the particular shapes of regions illustrated herein, and are to include deviations in shapes that result from, for example, manufacturing. Various regions illustrated in the figures are schematic in nature and their shapes may not be intended to illustrate the actual shape of a region of a device and are not intended to limit the scope of the present disclosure. Further, in the drawings, the sizes and relative sizes of layers and regions may be exaggerated for clarity.

For the sake of brevity, conventional elements, structures, or layers included in a semiconductor package including a connection pad, an adhesive layer, an isolation layer, a barrier metal pattern, a seed layer, etc. may or may not be described in detail herein. For example, descriptions of certain connection pads of a semiconductor chip connected to solder balls or bumps in a semiconductor package may be omitted herein when these structural elements are not related to certain features of the embodiments. Also, descriptions of materials forming well-known structural elements may be omitted herein when those materials are not relevant to certain features of the embodiments. Herein, the term "connection" between two structures or elements may refer to an electrical connection therebetween. For example, a connection between semiconductor chips, semiconductor packages, and/or semiconductor devices may refer to an electrical connection of a corresponding two or more elements to each other. The terms "coupled" and "connected" may have the same meaning and may be used interchangeably herein. Further, the term "isolation" between two structures or elements pertains to electrical insulation or separation therebetween. For example, isolation of wiring patterns from each other may mean that the wiring patterns are not electrically connected to each other.

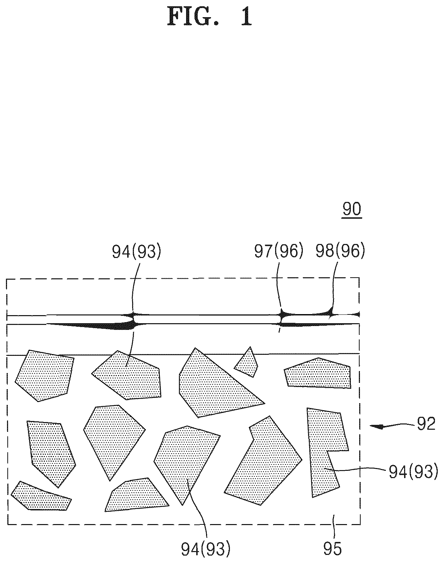

Hereinafter, various non-limiting example embodiments of the present disclosure are described with reference to FIGS. 1-17.

The use of a hybrid diamond thermal interposer integrated with a high thermal conductive thermal interface material (TIM) can significantly improve thermal performance without sacrificing mechanical integrity of a package. For example, a hybrid diamond thermal interposer 90 is described below with reference to FIG. 1.

FIG. 1 illustrates a schematic magnified cross-sectional view of the hybrid diamond thermal interposer 90 according to an example embodiment of the present disclosure.

With reference to FIG. 1, the hybrid diamond thermal interposer 90 may be provided, which may be a thermal interposer including a hybrid diamond structure. The hybrid diamond thermal interposer 90 may include a hybrid diamond layer 92 and an outer layer 96.

The hybrid diamond layer 92 may include a diamond skeleton 93 and a metal matrix 95 (also referred to as a metal) within and around the diamond skeleton 93. The diamond skeleton 93 may include diamond particles 94 (also referred to as a diamond filler) that are within the metal matrix 95. The metal matrix 95 may be within the diamond skeleton 93 such as to surround the diamond particles 94. According to some example embodiments of the present disclosure, the metal matrix 95 may include or consist of at least one metal such as, for example, silver (Ag), copper (Cu), etc.

The outer layer 96 may surround at least a portion of the hybrid diamond layer 92. For example, the outer layer 96 may be on one or more (e.g., some or all) from among a top surface, a bottom surface, and side surfaces (e.g., four side surfaces) of the hybrid diamond layer 92. For example, the outer layer 96 may be plated onto one or more (e.g., some or all) from among the top surface, the bottom surface, and side surfaces (e.g., four side surfaces) of the hybrid diamond layer 92.

The outer layer 96 may include, for example, a first outer layer 97 and a second outer layer 98. The first outer layer 97 may be directly on the one or more (e.g., some or all) from among the top surface, the bottom surface, and side surfaces (e.g., four side surfaces) of the hybrid diamond layer 92, such as to surround at least the portion of the hybrid diamond layer 92. The second outer layer 98 may also be on the one or more (e.g., some or all) from among the top surface, the bottom surface, and side surfaces (e.g., four side surfaces) of the hybrid diamond layer 92, such as to surround at least the portion of the hybrid diamond layer 92. For example, the second outer layer 98 may be directly on an outer surface of the first outer layer 97, such that the first outer layer 97 is between the second outer layer 98 and the hybrid diamond layer 92.

For example, the first outer layer 97 may be plated onto the one or more (e.g., some or all) from among the top surface, the bottom surface, and side surfaces (e.g., four side surfaces) of the hybrid diamond layer 92, and the second outer layer 98 may be plated onto the outer surface of the first outer layer 97. According to some example embodiments of the present disclosure, the first outer layer 97 may include or consist of, for example, nickel (Ni), and the second outer layer 98 may include or consist of, for example, gold (Au).

According to some example embodiments of the present disclosure, the hybrid diamond thermal interposer 90 (e.g., the hybrid diamond layer 92) may not include any organic materials.

With reference to TABLE 1 below, thermal conductivity of a hybrid diamond (e.g., the hybrid diamond layer 92) may be about 600 W/m·K, while the thermal conductivity of silicon (Si) may be about 200 W/m·K. In other words, the thermal conductivity of the hybrid diamond (e.g., the hybrid diamond layer 92) may be higher than the thermal conductivity of silicon (Si) by about a factor of three. Thus, by placing the hybrid diamond (e.g., the hybrid diamond thermal interposer 90 including the hybrid diamond layer 92) on top of silicon (Si) and/or on top of an HBM package(s), thermal performance of a semiconductor device (e.g., an advanced package) may be improved.

**TABLE 1: Example Characteristics**

| | Hybrid Diamond | Silicon (Si) | Copper Heat |
|---|---|---|---|
| | | | Spreader (HS) |
| Thermal Conductivity (W/m·K) | ~600 | ~200 | ~400 |
| CTE (ppm/°C) | ~10 | ~3 | ~18 |

Additionally, with reference to TABLE 1 above, the coefficient of thermal expansion (CTE) value of the hybrid diamond (e.g., the hybrid diamond layer 92) may be about 10 ppm/°C, while the CTE value of silicon (Si) may be about 3 ppm/°C and the CTE value of copper (e.g., a copper heat spreader (HS)) may be about 18 ppm/°C. Thus, the mechanical integrity of a semiconductor device (e.g., a semiconductor package) may be maintained when a thermal interposer (e.g., the hybrid diamond thermal interposer 90), according to some example embodiments of the present disclosure, is used between a silicon (Si) die (e.g., a semiconductor chip) and a copper (Cu) heat spreader. This is because the use of a thermal interposer material with an intermediate CTE value may generate a low thermomechanical stress in a semiconductor device (e.g., a semiconductor package).

In contrast to a thermal interposer (e.g., the hybrid diamond thermal interposer 90) according to some example embodiments of the present disclosure, a low-quality TIM can harden or leak out over time (e.g., crack, delaminate, pump-out, etc.), leading to increase of thermal resistance and, in turn, resulting in overheating or premature failure of high performance devices.

The risk of cracking or leaking of a TIM may be mitigated by the reduced CTE mismatch between a thermal interposer (e.g., the hybrid diamond thermal interposer 90), according to some example embodiments of the present disclosure, and a heat spreader. Hence, according to some example embodiments of the present disclosure, the reliability of a TIM may be improved throughout the lifetime of a device.

According to some example embodiments of the present disclosure, a thermal interposer (e.g., the hybrid diamond thermal interposer 90) may be provided and include a metal matrix (e.g., the metal matrix 95, which may include, for example, silver or copper) in a diamond skeleton (e.g., the diamond skeleton 93) and may not include any organic materials. Accordingly, the combination of the metal matrix (e.g., the metal matrix 95) and the diamond skeleton (e.g., the diamond skeleton 93) may adhere well, with no blistering, to the outer layer (e.g., the outer layer 96, which may include plated nickel and/or gold layers) even at a high temperature (e.g., about 400°C). Accordingly, there is a low risk of thermal resistance at the interfaces of the hybrid diamond layer (e.g., the hybrid diamond layer 92).

According to some example embodiments of the present disclosure, a hybrid diamond thermal interposer (e.g., the hybrid diamond thermal interposer 90) may be implemented in semiconductor devices such as, for example, high power devices and high performance advanced packages.

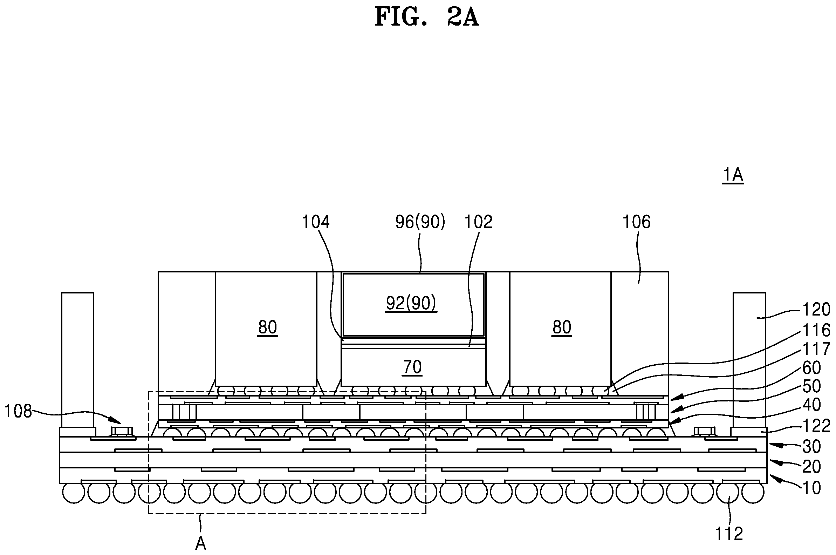

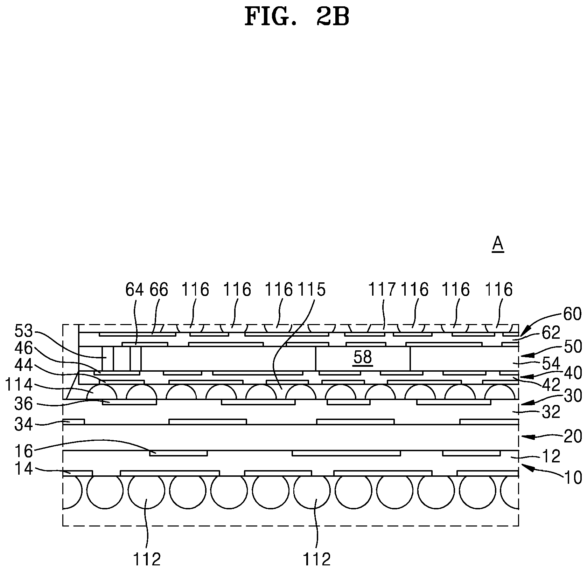

Examples of semiconductor devices according to some example embodiments of the present disclosure are described below with reference to FIGS. 2A-9. FIGS. 2A and 3-9 illustrate schematic cross-sectional views of semiconductor devices according to some example embodiments of the present disclosure. FIG. 2B illustrates a schematic magnified view of a part A of FIG. 2A.

With reference to FIGS. 2A-6, a semiconductor device may be provided that may be an advanced package. For example, the semiconductor device may include a 2.5D architecture. For example, the semiconductor devices of FIGS. 2A-6A may be configured for high performance applications (e.g., network, artificial intelligence (AI), high performance computing (HPC), mobile, wearable, etc.).

For example, with reference to FIGS. 2A-B, a semiconductor device 1A may be provided. The semiconductor device 1A may include, for example, a first lower redistribution layer 10, a substrate 20, a first upper redistribution layer 30, a second lower redistribution layer 40, an interposer 50, a second upper redistribution layer 60, a first semiconductor chip 70, at least one second semiconductor chip 80 (or a semiconductor device), and the hybrid diamond thermal interposer 90.

The first lower redistribution layer 10 may be configured to electrically connect components that are above and/or below the first lower redistribution layer 10. For example, the first lower redistribution layer 10 may be configured to electrically connect the substrate 20, that is above the first lower redistribution layer 10, to one or more first bumps 112 that are below the first lower redistribution layer 10.

A top surface of the first lower redistribution layer 10 may be on a bottom surface of the substrate 20. For example, the top surface of the first lower redistribution layer 10 may be in direct contact with the bottom surface of the substrate 20. The one or more first bumps 112 may be on a bottom surface of the first lower redistribution layer 10. For example, the one or more first bumps 112 may be in direct contact with the bottom surface of the first lower redistribution layer 10. According to some example embodiments of the present disclosure, the one or more first bumps 112 may be external bumps that are configured to electrically connect the semiconductor device 1A to at least one external component. The one or more first bumps 112 may be, for example, ball grid array (BGA) solder balls.

With reference to FIG. 2B, the first lower redistribution layer 10 may include at least one dielectric layer 12, and at least one connection element (e.g., a metal element) that is configured to electrically connect the components that are above and/or below the first lower redistribution layer 10. For example, the at least one connection element may include upper metal layers 16 and lower metal layers 14 that are respectively at the upper and lower surfaces of the at least one dielectric layer 12. The at least one connection element may further include at least one via, within the at least one dielectric layer 12, that electrically connects together the upper metal layers 16 and lower metal layers 14.

The substrate 20 may be configured to electrically connect components that are above and/or below the substrate 20. For example, the substrate 20 may be configured to electrically connect the first upper redistribution layer 30, that is above the substrate 20, to the first lower redistribution layer 10 that is below the substrate 20. According to some example embodiments of the present disclosure, the substrate 20 may be an organic substrate. For example, the substrate 20 may be a substrate that primarily includes an organic material. For example, the substrate 20 may be a bismaleimide trizaine (BT) core substrate that includes BT. According to some example embodiments of the present disclosure, the substrate 20 may be a glass substrate or a ceramic substrate. For example, the substrate 20 may be a substrate that primarily includes a ceramic or glass. According to some example embodiments of the present disclosure, the substrate 20 may include at least one connection element (e.g., a metal element) that is configured to electrically connect the components that are above and/or below the substrate 20.

The first upper redistribution layer 30 may be configured to electrically connect components that are above and/or below the first upper redistribution layer 30. For example, the first upper redistribution layer 30 may be configured to electrically connect one or more second bumps 114 (see FIG. 2B), that are above the first upper redistribution layer 30, to the substrate 20 that is below the first upper redistribution layer 30.

A bottom surface of the first upper redistribution layer 30 may be on a top surface of the substrate 20. For example, the bottom surface of the first upper redistribution layer 30 may be in direct contact with the top surface of the substrate 20. The one or more second bumps 114 may be on a top surface of the first upper redistribution layer 30. For example, the one or more second bumps 114 may be in direct contact with the top surface of the first upper redistribution layer 30. The one or more second bumps 114 may be, for example, C4 solder bumps. According to some example embodiments of the present disclosure, the one or more second bumps 114 may be surrounded in at least one horizontal direction by an underfill 115 that is on (e.g., in direct contact with) the upper surface of the first upper redistribution layer 30.

With reference to FIG. 2B, the first upper redistribution layer 30 may include at least one dielectric layer 32, and at least one connection element (e.g., a metal element) that is configured to electrically connect the components that are above and/or below the first upper redistribution layer 30. For example, the at least one connection element may include upper metal layers 36 and lower metal layers 34 that are respectively at the upper and lower surfaces of the at least one dielectric layer 32. The at least one connection element may further include at least one via, within the at least one dielectric layer 32, that electrically connects together the upper metal layers 36 and lower metal layers 34.

The second lower redistribution layer 40, the interposer 50, and the second upper redistribution layer 60 may be provided on (e.g., above) the combination of the first lower redistribution layer 10, the substrate 20, and the first upper redistribution layer 30.

The second lower redistribution layer 40 may be configured to electrically connect components that are above and/or below the second lower redistribution layer 40. For example, the second lower redistribution layer 40 may be configured to electrically connect the interposer 50, that is above the second lower redistribution layer 40, to the one or more second bumps 114 that are below the second lower redistribution layer 40.

A top surface of the second lower redistribution layer 40 may be on a bottom surface of the interposer 50. For example, the top surface of the second lower redistribution layer 40 may be in direct contact with the bottom surface of the interposer 50. The one or more second bumps 114 may be on a bottom surface of the second lower redistribution layer 40. For example, the one or more second bumps 114 may be in direct contact with the bottom surface of the second lower redistribution layer 40.

With reference to FIG. 2B, the second lower redistribution layer 40 may include at least one dielectric layer 42, and at least one connection element (e.g., a metal element) that is configured to electrically connect the components that are above and/or below the second lower redistribution layer 40 . For example, the at least one connection element may include upper metal layers 46 and lower metal layers 44 that are respectively at the upper and lower surfaces of the at least one dielectric layer 42. The at least one connection element may further include at least one via, within the at least one dielectric layer 42, that electrically connects together the upper metal layers 46 and lower metal layers 44.

The interposer 50 may be configured to electrically connect components that are above and/or below the interposer 50. For example, the interposer 50 may be configured to electrically connect the second upper redistribution layer 60, that is above the interposer 50, to the second lower redistribution layer 40, that is below the interposer 50. According to some example embodiments of the present disclosure, the interposer 50 may be an organic interposer. For example, the interposer 50 may be an interposer that primarily includes an organic material 54. According to some example embodiments of the present disclosure, the interposer 50 may be a 2.5D interposer.

According to some example embodiments of the present disclosure, the interposer 50 may include at least one connection element that is configured to electrically connect the components that are above and/or below the interposer 50. For example, the interposer 50 may include at least one via 53 (e.g., at least one a through via) and/or at least one bridge die 58.

The at least one via 53 may be configured to electrically connect at least one component (e.g., the second upper redistribution layer 60) that is above the interposer 50 to at least one component (e.g., the second lower redistribution layer 40) that is below the interposer 50. The at least one via 53 may extend through the organic material 54 from the top surface to the bottom surface of the interposer 50. As shown in FIG. 2A, four vias 53 may be provided (e.g., two vias 52 at each of two outer sides of the interposer 50), but embodiments of the present disclosure are not limited thereto. The at least one via 53 may include, for example, a metal material.

The at least one bridge die 58 may be configured to electrically connect together two or more components that are above the interposer 50. The at least one bridge die 58 may be at least partially surrounded by the organic material 54 in at least one horizontal direction. As shown in FIG. 2A, two bridge dies 58 may be provided, but embodiments of the present disclosure are not limited thereto. According to some example embodiments of the present disclosure, one of the bridge dies 58 may be configured to electrically connect together one of the second semiconductor chips 80 and the first semiconductor chip 70 through the second upper redistribution layer 60, and may be overlapped by the one of the second semiconductor chips 80 and the first semiconductor chip 70. Also, another one of the bridge dies 58 may be configured to electrically connect together another one of the second semiconductor chips 80 and the first semiconductor chip 70 through the second upper redistribution layer 60, and may be overlapped by the other one of the second semiconductor chips 80 and the first semiconductor chip 70. However, embodiments of the present disclosure are not limited thereto.

The second upper redistribution layer 60 may be configured to electrically connect components that are above and/or below the second upper redistribution layer 60. For example, the second upper redistribution layer 60 may be configured to electrically connect one or more third bumps 116, that are above the second upper redistribution layer 60, to the interposer 50 that is below the second upper redistribution layer 60.

A bottom surface of the second upper redistribution layer 60 may be on a top surface of the interposer 50. For example, the bottom surface of the second upper redistribution layer 60 may be in direct contact with the top surface of the interposer 50. The one or more third bumps 116 may be on a top surface of the second upper redistribution layer 60. For example, the one or more third bumps 116 may be in direct contact with the top surface of the second upper redistribution layer 60. The one or more third bumps 116 may be, for example, micro solder bumps.

With reference to FIG. 2B, the second upper redistribution layer 60 may include at least one dielectric layer 62, and at least one connection element (e.g., a metal element) that is configured to electrically connect the components that are above and/or below second upper redistribution layer 60. For example, the at least one connection element may include upper metal layers 66 and lower metal layers 64 that are respectively at the upper and lower surfaces of the at least one dielectric layer 62. The at least one connection element may further include at least one via, within the at least one dielectric layer 62, that electrically connects together the upper metal layers 66 and lower metal layers 64.

The first semiconductor chip 70 and the at least one second semiconductor chip 80 may be provided on (e.g., above) the combination of the second lower redistribution layer 40, the interposer 50, and the second upper redistribution layer 60.

According to some example embodiments of the present disclosure, as shown in FIG. 2A, the first semiconductor chip 70 may be between at least two of the second semiconductor chips 80 in the horizontal direction, but embodiments of the present disclosure are not limited thereto. Sets of the third bumps 116 may be provided underneath the first semiconductor chip 70 and the at least one second semiconductor chip 80, respectively, such as to be electrically connected thereto. For example, the first semiconductor chip 70 may be electrically connected to a first set of the third bumps 116 underneath the first semiconductor chip 70, one of the second semiconductor chips 80 may be electrically connected to a second set of the third bumps 116 underneath the one of the second semiconductor chips 80, and another one of the second semiconductor chips 80 may be electrically connected to a third set of the third bumps 116 underneath the other one of the second semiconductor chips 80. Through the sets of the third bumps 116, the first semiconductor chip 70 and the at least one second semiconductor chip 80 may be electrically connected to the second upper redistribution layer 60. According to some example embodiments of the present disclosure, each of the sets of the third bumps 116 may be surrounded in at least one horizontal direction by a respective underfill 117 that is on (e.g., in direct contact with) the top surface of the second upper redistribution layer 60.

By being electrically connected to the second upper redistribution layer 60, the first semiconductor chip 70 and/or the at least one second semiconductor chip 80 may be further electrically connected to one or more (e.g., some or all) from among the interposer 50 (e.g., the vias 53 and/or the bridge dies 58), the second lower redistribution layer 40, the second bumps 114, the first upper redistribution layer 30, the substrate 20, the first lower redistribution layer 10, and the first bumps 112. According to some example embodiments of the present disclosure, the first semiconductor chip 70 may be electrically connected together to the at least one second semiconductor chip 80 through the third bumps 116, and one or more from among the second upper redistribution layer 60, the interposer 50 (e.g., the vias 53 and/or the bridge dies 58), the second lower redistribution layer 40, the second bumps 114, the first upper redistribution layer 30, the substrate 20, the first lower redistribution layer 10, and the first bumps 112. For example, the first semiconductor chip 70 may be electrically connected to the at least one second semiconductor chip 80 through the third bumps 116, the second upper redistribution layer 60, and the bridge dies 58 of the interposer 50.

According to some example embodiments of the present disclosure, the first semiconductor chip 70 may be a logic die (e.g., a logic chip), and each of the second semiconductor chips 80 may be a memory chip (e.g., an HBM). According to some example embodiments of the present disclosure, the logic die (e.g., the logic chip) may have a much higher power requirement than the memory chip (e.g., the HBM).

According to some example embodiments of the present disclosure, a metal pad 102 may be provided (e.g., deposited) on a top surface of the first semiconductor chip 70. For example, a bottom surface of the metal pad 102 may be in direct contact with the top surface of the first semiconductor chip. A shape of the metal pad 102, in a plan view, may correspond to (e.g., be the same as) a shape of the first semiconductor chip 70 in the plan view. For example, side surfaces of the metal pad 102 and side surfaces of the first semiconductor chip 70 may be coplanar with each other, but embodiments of the present disclosure are not limited thereto. The metal pad 102 may be configured to make a metallic solder joint between a semiconductor chip (e.g., the first semiconductor chip 70) and the hybrid diamond thermal interposer 90. According to some example embodiments of the present disclosure, the metal pad 102 may include at least one layer of metal. For example, the at least one layer of the metal pad 102 may include (a) a nickel (Ni) layer and a gold (Au) layer; (b) a titanium (Ti) layer, a nickel (Ni)-vanadium (V) layer, and a palladium (Pd) layer; (c) a titanium (Ti) layer, a nickel (Ni)-vanadium (V) layer, and a gold (Au) layer; (d) a titanium (Ti) layer, a nickel (Ni)-vanadium (V) layer, and a copper (Cu) layer, (e) etc. According to some example embodiments of the present disclosure, the at least one layer of the metal pad 102 may be formed on the first semiconductor chip 70 by a sputtering process.

According to some example embodiments of the present disclosure, a first TIM 104 may be provided on a top surface of the metal pad 102. For example, a bottom surface of the first TIM 104 may be in direct contact with the top surface of the metal pad 102. Also, a top surface of the first TIM 104 may be in direct contact with a bottom surface of the hybrid diamond thermal interposer 90 (e.g., a bottom surface of the second outer layer 98 of the outer layer 96 on the bottom surface of the hybrid diamond layer 92). A shape of the first TIM 104, in a plan view, may correspond to (e.g., be the same as) a shape of metal pad 102 and/or the hybrid diamond thermal interposer 90 in the plan view. For example, side surfaces of the first TIM 104, side surfaces of metal pad 102, and/or side surfaces of the hybrid diamond thermal interposer 90 may be coplanar with each other, but embodiments of the present disclosure are not limited thereto. The first TIM 104, with the metal pad 102, may be configured to make a metallic solder joint between a semiconductor chip (e.g., the first semiconductor chip 70) and the hybrid diamond thermal interposer 90. According to some example embodiments of the present disclosure, the first TIM 104 may include any type of solder material including, but not limited to, an SAC (SnAgCu) alloy, an Sn5Sb alloy, and a low melting temperature solder (e.g., eutectic 42Sn58Bi alloy, eutectic 48Sn52In alloy, etc.).

According to some example embodiments of the present disclosure, a mold material 106 may be provided on (e.g., in direct contact with) the second upper redistribution layer 60. For example, the mold material 106 may surround, in at least one horizontal direction, the third bumps 116, the underfills 117, the first semiconductor chip 70, the at least one second semiconductor chip 80, the metal pad 102, the first TIM 104, and the hybrid diamond thermal interposer 90. For example, the mold material 106 may be in direct contact with side surfaces of the underfills 117, side surfaces of the first semiconductor chip 70, side surfaces of the at least one second semiconductor chip 80, side surfaces of the metal pad 102, side surfaces of the first TIM 104, and side surfaces of the hybrid diamond thermal interposer 90.

According to some example embodiments of the present disclosure, a shape of the mold material 106, in a plan view, may correspond to (e.g., be the same as) a shape of the second upper redistribution layer 60, in the plan view. For example, side surfaces of the mold material 106 and side surfaces of the second upper redistribution layer 60 may be coplanar with each other, but embodiments of the present disclosure are not limited thereto. According to some example embodiments of the present disclosure, upper surfaces of the at least one second semiconductor chip 80 and the hybrid diamond thermal interposer 90 may be exposed from the mold material 106. For example, upper surfaces of the at least one second semiconductor chip 80 and the hybrid diamond thermal interposer 90 may be coplanar with an upper surface of the mold material 106.

According to some example embodiments of the present disclosure, a semiconductor chip cap 108 may be provided on the top surface of the first upper redistribution layer 30. For example, the semiconductor chip cap 108 may include a plurality of capacitors that surrounds the second lower redistribution layer 40, the interposer 50, and the second upper redistribution layer 60 in at least one horizontal direction.

According to some example embodiments of the present disclosure, a stiffener ring 120 may be provided on the top surface of the first upper redistribution layer 30. For example, the stiffener ring 120 may be attached to outer sides of the top surface of the first upper redistribution layer 30 by an adhesive 122.

According to some example embodiments of the present disclosure, one or more (e.g., some or all) of the first lower redistribution layer 10, the substrate 20, the first upper redistribution layer 30, the second lower redistribution layer 40, the interposer 50, the second upper redistribution layer 60, the first semiconductor chip 70, the at least one second semiconductor chip 80, the hybrid diamond thermal interposer 90, the mold material 106, the semiconductor chip cap 108, and the stiffener ring 120 may have a rectangular shape (e.g., a square shape) in a plan view, but embodiments of the present disclosure are not limited thereto.

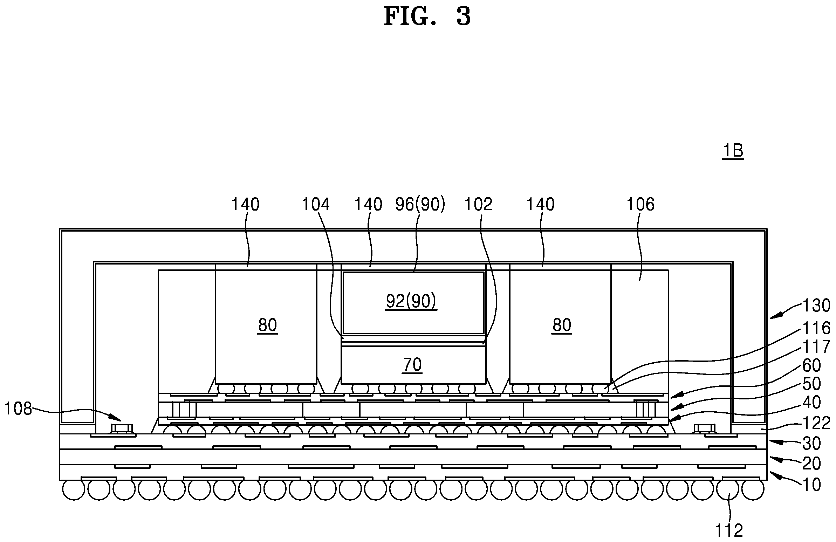

With reference to FIG. 3, a semiconductor device 1B may be provided. The semiconductor device 1B may be similar to the semiconductor device 1A described above with reference to FIGS. 2A-B, except that, for example, a heat spreader 130 may be provided instead of the stiffener ring 120. Accordingly, repeated descriptions of the semiconductor device 1B may be omitted.

The heat spreader 130 may be configured to distribute heat from components such as, for example, the first semiconductor chip 70 and the at least one second semiconductor chip 80. For example, the heat spreader 130 may be provided on the top surface of the first upper redistribution layer 30. For example, the heat spreader 130 may be attached to outer sides of the top surface of the first upper redistribution layer 30 by the adhesive 122. The heat spreader 130 may extend vertically from the outer sides of the top surface of the first upper redistribution layer 30 to above the top surfaces of the at least one second semiconductor chip 80 and the hybrid diamond thermal interposer 90, and may extend horizontally such as to be above (e.g., in an overlapping manner) the top surfaces of the at least one second semiconductor chip 80 and the hybrid diamond thermal interposer 90. According to some example embodiments of the present disclosure, the heat spreader 130 may be configured as a lid of the semiconductor device 1B. According to some example embodiments of the present disclosure, the heat spreader 130 may be made of a metal (e.g., copper). According to some example embodiments of the present disclosure, the heat spreader 130 may be coated with at least one metal (e.g., nickel (Ni) and/or gold (Au)).

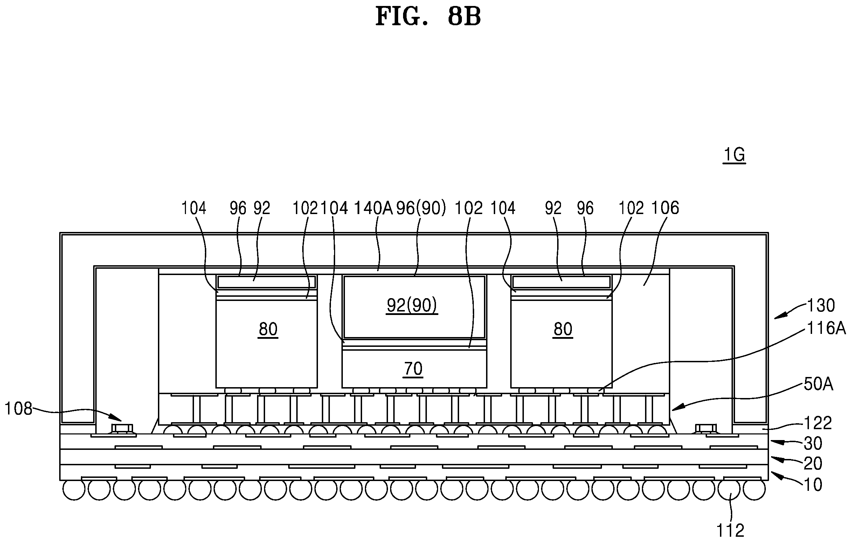

According to some example embodiments of the present disclosure, second TIMs 140 may be respectively provided on the top surfaces of the at least one second semiconductor chip 80 and the hybrid diamond thermal interposer 90, such as to attach the top surfaces of the at least one second semiconductor chip 80 and the hybrid diamond thermal interposer 90 to portions of the heat spreader 130 thereabove. Alternatively, the second TIM 140A (see FIG. 8B) may be provided as a contiguous layer that extends on the top surfaces of the at least one second semiconductor chip 80 and the hybrid diamond thermal interposer 90, such as to attach the top surfaces of the at least one second semiconductor chip 80 and the hybrid diamond thermal interposer 90 to portions of the heat spreader 130 thereabove. Thus, heat from the first semiconductor chip 70 may be transferred to the heat spreader 130 through the hybrid diamond thermal interposer 90 and the second TIM 140 (or the second TIM 140A) thereon, and heat from the at least one second semiconductor chip 80 may be transferred to the heat spreader 130 through the at least one second TIM 140 (or the second TIM 140A) thereon.

According to some example embodiments of the present disclosure, the second TIM 140 (or the second TIM 140A) may include, for example, a liquid metal (e.g., gallium (Ga)) or a liquid-like metal (e.g., a Ga-In alloy), graphite, thermal grease, etc.

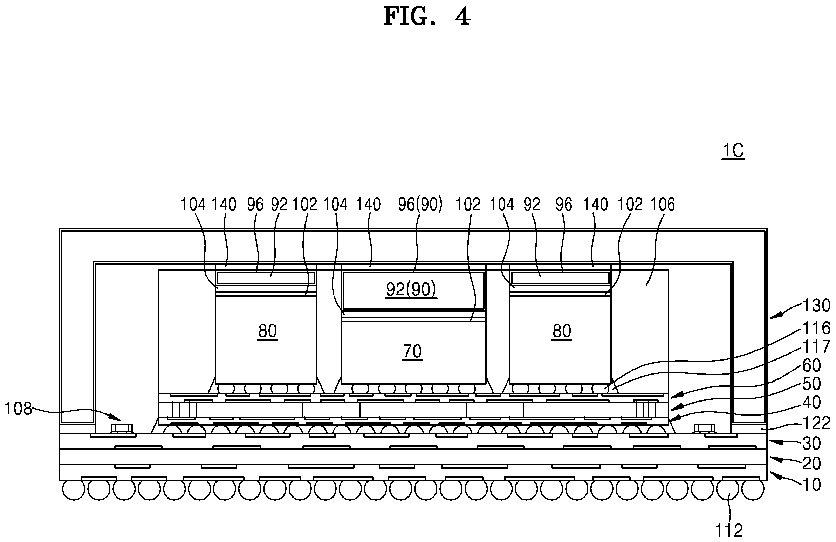

With reference to FIG. 4, a semiconductor device 1C may be provided. The semiconductor device 1C may be similar to the semiconductor device 1B described above with reference to FIG. 3, except that, for example, a plurality of the metal pads 102, a plurality of the first TIMs 104, and a plurality of the hybrid diamond thermal interposers 90 may be provided. Accordingly, repeated descriptions of the semiconductor device 1C may be omitted.

As shown in FIG. 4, respective sets of metal pads 102, first TIMs 104, and the hybrid diamond thermal interposers 90 may be provided on the top surfaces of each of the first semiconductor chip 70 and the at least one second semiconductor chip 80. For example, a metal pad 102 may be additionally provided on the top surface of each second semiconductor chip 80, a first TIM 104 may be provided on such metal pad 102, and a hybrid diamond thermal interposer 90 may be provided on such first TIM 104, such as to be bonded to the second semiconductor chip 80 by such metal pad 102 and such first TIM 104. Thus, heat from the first semiconductor chip 70 may be transferred to the heat spreader 130 through the hybrid diamond thermal interposer 90 and the second TIM 140 (or the second TIM 140A) thereon, and heat from each second semiconductor chip 80 may be transferred to the heat spreader 130 through the hybrid diamond thermal interposer 90 and the second TIM 140 (or the second TIM 140A) thereon.

According to some example embodiments of the present disclosure, the heat spreader 130 may be omitted and the stiffener ring 120 (see FIG. 2A) may be provided.

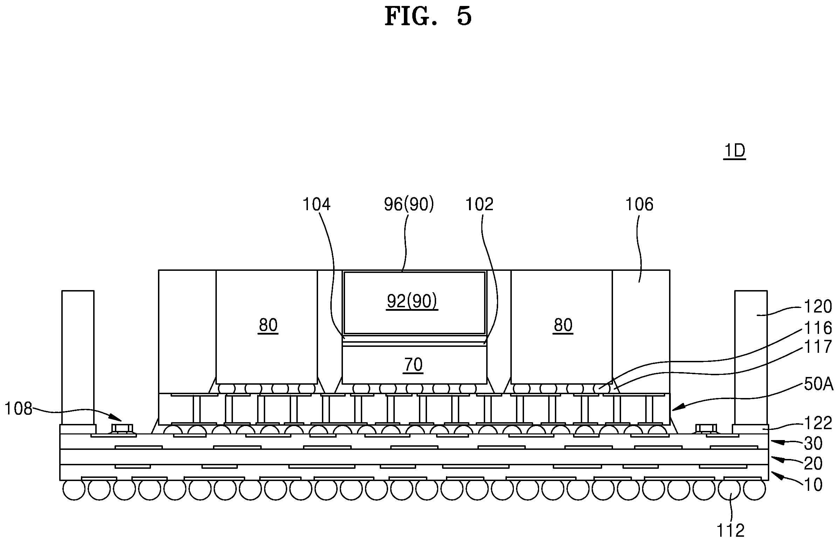

With reference to FIG. 5, a semiconductor device 1D may be provided. The semiconductor device 1D may be similar to the semiconductor device 1A described above with reference to FIGS. 2A-B, except that, for example, an interposer 50A may be provided instead of the interposer 50, the second lower redistribution layer 40, and the second upper redistribution layer 60. Accordingly, repeated descriptions of the semiconductor device 1D may be omitted.

According to some example embodiments of the present disclosure, the interposer 50A may be a silicon interposer. For example, the interposer 50A may primarily include silicon, instead of an organic material. According to some example embodiments of the present disclosure, the interposer 50A may be a 2.5D interposer.

The interposer 50A may be configured to electrically connect components that are above and/or below the interposer 50A. For example, the interposer 50A may be configured to electrically connect the third bumps 116A, that are above the interposer 50A, to the second bumps 114 (see FIG. 2A) that are below the interposer 50A.

According to some example embodiments of the present disclosure, the interposer 50A may include at least one connection element (e.g., a metal element) that is configured to electrically connect the components that are above and/or below the interposer 50A. For example, the interposer 50A may include upper metal layers and lower metal layers that are respectively at the upper and lower surfaces of the interposer 50A. The at least one connection element may further include at least one via (e.g., a through via), within the interposer 50A, that electrically connects together the upper metal layers and lower metal layers.

According to some example embodiments of the present disclosure, the semiconductor device 1D may include the heat spreader 130 (see Fig. 3) and the second TIMs 140, instead of the stiffener ring 120, such as to be similar to the semiconductor device 1B of FIG. 3 except for, for example, including the interposer 50A.

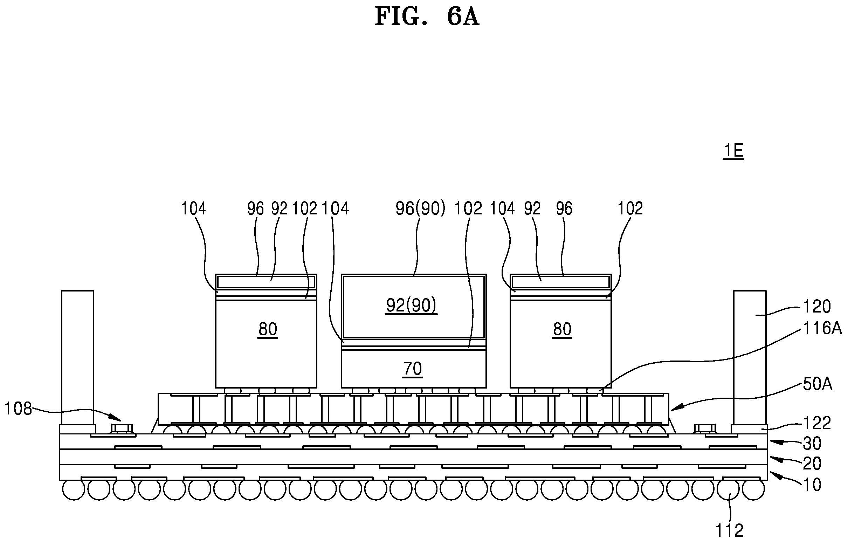

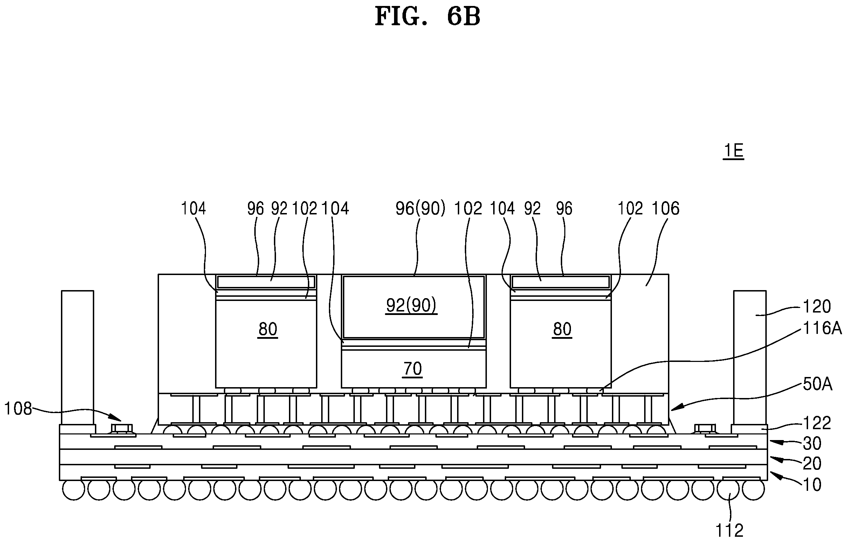

With reference to FIGS. 6A-B, a semiconductor device 1E may be provided. FIGS. 6A-B illustrate schematic cross-sectional views of the semiconductor device 1E according to example embodiments of the present disclosure.

The semiconductor device 1E may be similar to the semiconductor device 1D described above with reference to FIG. 5, except that, for example, a plurality of third bumps 116A may be provided instead of the plurality of third bumps 116 and the underfill 117. Additionally, with reference to FIG. 6A, the mold material 106 may be omitted. Accordingly, repeated descriptions of the semiconductor device 1E may be omitted.

According to some example embodiments of the present disclosure, the third bumps 116A may be, for example, hybrid copper bonds. For example, each of the first semiconductor chip 70 and the second semiconductor chips 80 may be directly bonded to the interposer 50A via the third bumps 116A (e.g., hybrid copper bonds). For example, each of the first semiconductor chip 70 and the second semiconductor chips 80 may be directly bonded to the interposer 50A via hybrid copper bonding (HCB). The hybrid copper bonds may include embedded metal (e.g., copper) portions bonded together and dielectric (e.g., SiOx) portions bonded together.

According to example embodiments of the present disclosure, the configurations (including the third bumps 116A) described above with reference to FIGS. 6A-B may also be implemented in, for example, the embodiments described above with reference to FIGS. 2A-5.

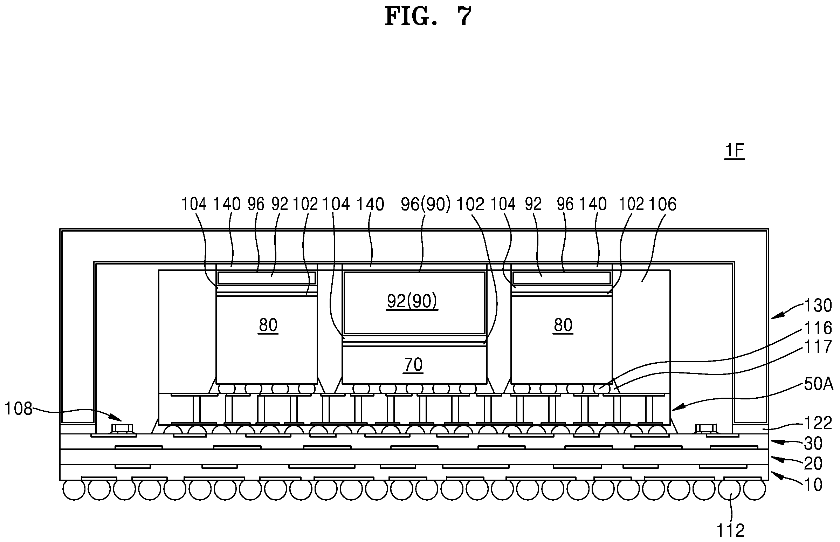

With reference to FIG. 7, a semiconductor device 1F may be provided. The semiconductor device 1F may be similar to the semiconductor device 1D described above with reference to FIG. 5, except that, for example, a plurality of the metal pads 102, a plurality of the first TIMs 104, and a plurality of the hybrid diamond thermal interposers 90 may be provided. Additionally, the heat spreader 130 and the second TIMs 140 may be provided, instead of the stiffener ring 120. Accordingly, repeated descriptions of the semiconductor device 1F may be omitted.

For example, respective sets of metal pads 102, first TIMs 104, the hybrid diamond thermal interposers 90, and second TIMs 140 may be provided on the top surfaces of each of the first semiconductor chip 70 and the at least one second semiconductor chip 80, in a similar manner as described above with respect to FIG. 4. Accordingly, repeated descriptions of the semiconductor device 1F may be omitted.

According to some example embodiments of the present disclosure, the heat spreader 130 may be omitted and the stiffener ring 120 (see FIG. 5) may be provided.

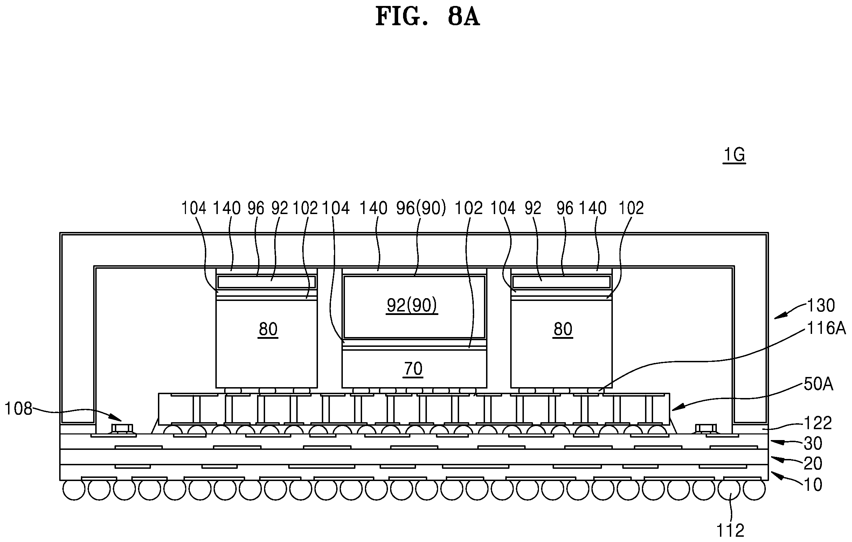

With reference to FIGS. 8A-B, a semiconductor device 1G may be provided. FIGS. 8A-B illustrate schematic cross-sectional views of the semiconductor device 1G according to example embodiments of the present disclosure.

The semiconductor device 1G may be similar to the semiconductor device 1F described above with reference to FIG. 7, except that, for example, the plurality of third bumps 116A may be provided instead of the plurality of third bumps 116 and the underfill 117. Additionally, with reference to FIG. 8A, the mold material 106 may be omitted. Accordingly, repeated descriptions of the semiconductor device 1G may be omitted. As described above, the third bumps 116A may be, for example, hybrid copper bonds. Accordingly, repeated description of the third bumps 116A may be omitted.

According to some example embodiments of the present disclosure, with reference to FIG. 8B, the second TIM 140A may be provided as a contiguous layer that extends on upper surfaces of the first semiconductor chip 70, the one or more (e.g., some or all) of the second semiconductor chips 80, and the mold material 106. For example, the second TIM 140A may be provided as a contiguous layer that extends on upper surfaces of each of the hybrid diamond thermal interposers 90 on the first semiconductor chip 70 and the one or more (e.g., some or all) of the second semiconductor chips 80, and on an upper surface of the mold material 106. For example, the second TIM 140A may be in direct contact with upper surfaces of the outer layer 96 of each of the hybrid diamond thermal interposers 90, and on an upper surface of the mold material 106.

According to example embodiments of the present disclosure, in a plan view, the second TIM 140A may have a same shape as the mold material 106, and side surfaces of the second TIM 140A and side surfaces of the mold material 106 may be coplanar with each other.

According to example embodiments of the present disclosure, the configurations (including the third bumps 116A) described above with reference to FIGS. 8A-B may also be implemented in the embodiments described above with reference to FIG. 7.

According to example embodiments of the present disclosure, the configurations (including the second TIM 140A) described above with reference to FIGS. 8B may also be implemented in other embodiments of the present disclosure that include the mold material 106 (e.g., embodiments shown in FIGS. 2A, 3-5, 6B, and 7.

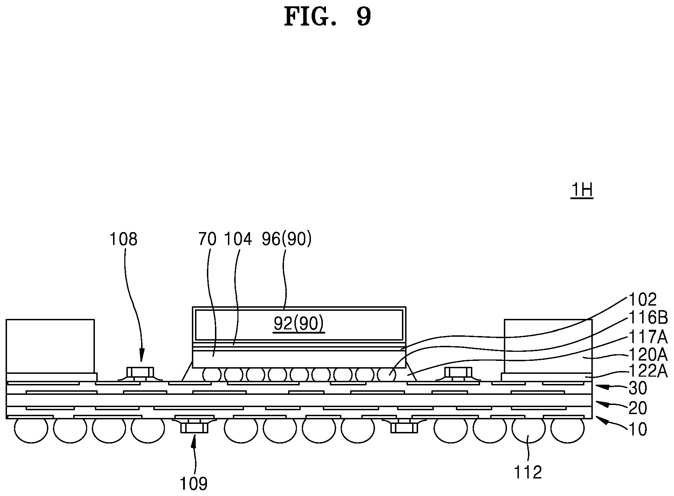

With reference to FIGS. 9-11, a semiconductor device that has a configuration of a flip chip ball grid array (BGA) may be provided. The semiconductor devices of FIGS. 9-11 may be configured for high power applications. In describing embodiments of FIGS. 9-11, descriptions that are repetitive with descriptions given above with respect to FIGS. 1-8 may be omitted.

For example, with reference to FIG. 9, a semiconductor device 1H may be provided.

In comparison to the semiconductor device 1A shown in FIG. 2A, the semiconductor device 1H may not include the second semiconductor chips 80, and may not include the second lower redistribution layer 40, the interposer 50, and the second upper redistribution layer 60. For example, the first semiconductor chip 70 may be mounted on and electrically connected to the first upper redistribution layer 30 by second bumps 116B, without the second lower redistribution layer 40, the interposer 50, and the second upper redistribution layer 60 being present.

According to some example embodiments of the present disclosure, the second bumps 116B may be C4 solder bumps. According to some example embodiments of the present disclosure, the second bumps 116B may be surrounded at least in one horizontal direction by an underfill 117A that is on (e.g., in direct contact with) the top surface of the first upper redistribution layer 30. According to some example embodiments of the present disclosure, a semiconductor chip cap 109 may be provided on the bottom surface of the first lower redistribution layer 10.

According to some example embodiments of the present disclosure, a stiffener ring 120A may be provided on the top surface of the first upper redistribution layer 30. For example, the stiffener ring 120A may be attached to outer sides of the top surface of the first upper redistribution layer 30 by an adhesive 122A. According to some example embodiments of the present disclosure, the stiffener ring 120A may have a rectangular shape (e.g., a square shape) in a plan view, but embodiments of the present disclosure are not limited thereto.

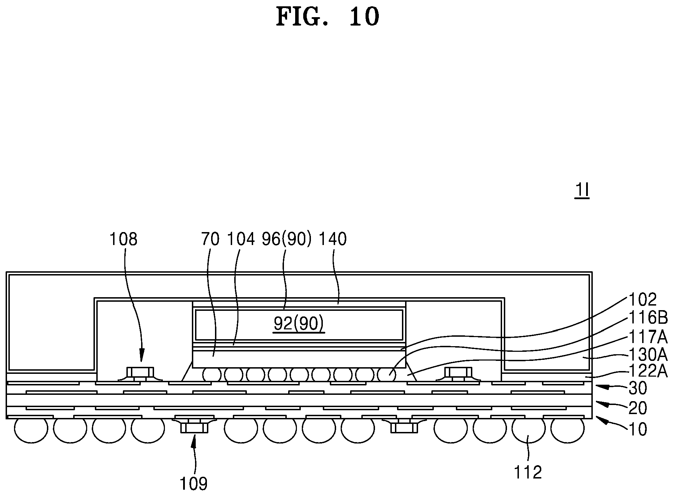

With reference to FIG. 10, a semiconductor device 1I may be provided. The semiconductor device 1I may be similar to the semiconductor device 1H described above with reference to FIG. 9, except that, for example, a heat spreader 130A may be provided instead of the stiffener ring 120A. Accordingly, repeated descriptions of the semiconductor device 1I may be omitted.

The heat spreader 130A may be configured to distribute heat from components such as, for example, the first semiconductor chip 70. For example, the heat spreader 130A may be provided on the top surface of the first upper redistribution layer 30. For example, the heat spreader 130A may be attached to outer sides of the top surface of the first upper redistribution layer 30 by an adhesive 122A. As shown in FIG. 10, the heat spreader 130A may extend vertically from the outer sides of the top surface of the first upper redistribution layer 30 to above the top surface of the hybrid diamond thermal interposer 90, and may extend horizontally such as to be above (e.g., in an overlapping manner) the top surface of the hybrid diamond thermal interposer 90. Thus, heat from the first semiconductor chip 70 may be transferred to the heat spreader 130A through the hybrid diamond thermal interposer 90 and the second TIM 140 (or the second TIM 140A) thereon. According to some example embodiments of the present disclosure, the heat spreader 130A may be configured as a lid of the semiconductor device 1I.

According to some example embodiments of the present disclosure, the heat spreader 130A may be made of a metal (e.g., copper (Cu)). According to some example embodiments of the present disclosure, the heat spreader 130A may be coated with at least one metal (e.g., nickel (Ni) and/or gold (Au)). According to some example embodiments of the present disclosure, the heat spreader 130A may have a rectangular shape (e.g., a square shape) in a plan view, but embodiments of the present disclosure are not limited thereto.

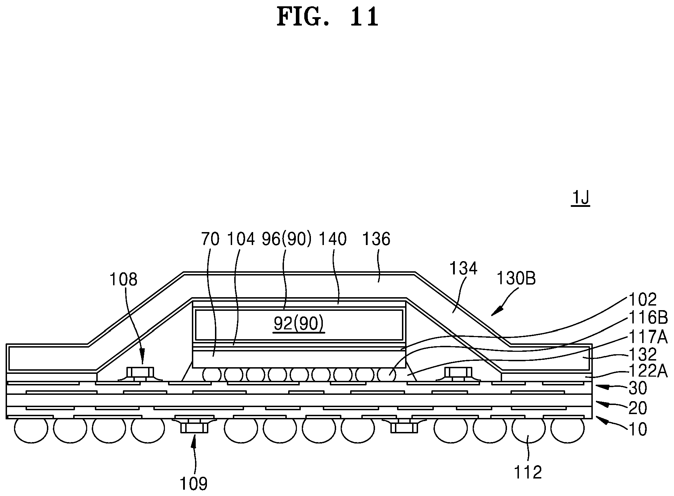

With reference to FIG. 11, a semiconductor device 1J may be provided. The semiconductor device 1J may be similar to the semiconductor device 1I described above with reference to FIG. 10, except that, for example, a heat spreader 130B may be provided instead of the heat spreader 130A. Accordingly, repeated descriptions of the semiconductor device 1J may be omitted.

The heat spreader 130B may have a different shape than a shape of the heat spreader 130A. For example, the heat spreader 130B may include first horizontal portion 132, an inclined portion 134, and a second horizontal portion 136.

The first horizontal portion 132 may extend, on the adhesive 122A in a horizontal direction towards to the first semiconductor chip 70 and the hybrid diamond thermal interposer 90. The inclined portion 134 may be directly connected to the first horizontal portion 132 and may extend from the first horizontal portion 132 in an inclined direction (horizontally and vertically) towards and above the first semiconductor chip 70 and the hybrid diamond thermal interposer 90. The second horizontal portion 136 may be directly connected to the inclined portion 134, may extend horizontally above the top surface of the hybrid diamond thermal interposer 90, and may be connected to the hybrid diamond thermal interposer 90 by the second TIM 140 (or the second TIM 140A).

According to some example embodiments of the present disclosure, the heat spreader 130B may be made of a metal (e.g., copper). According to some example embodiments of the present disclosure, the heat spreader 130B may be coated with at least one metal (e.g., nickel (Ni) and/or gold (Au)). According to some example embodiments of the present disclosure, the heat spreader 130B may have a rectangular shape (e.g., a square shape) in a plan view, but embodiments of the present disclosure are not limited thereto.

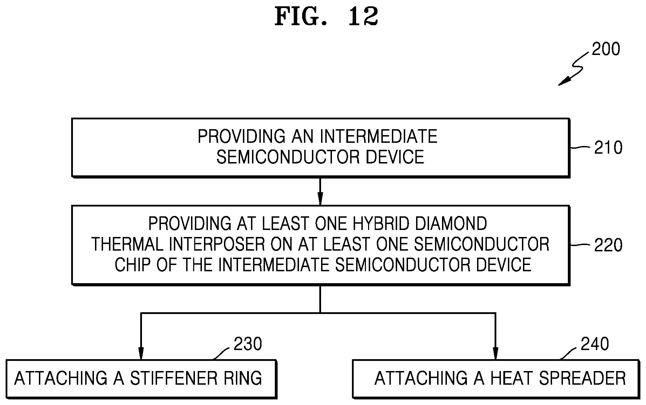

According to some example embodiments of the present disclosure, with reference to FIGS. 12-16, a method of manufacturing semiconductor devices (e.g., the semiconductor devices 1A-1H) may be provided.

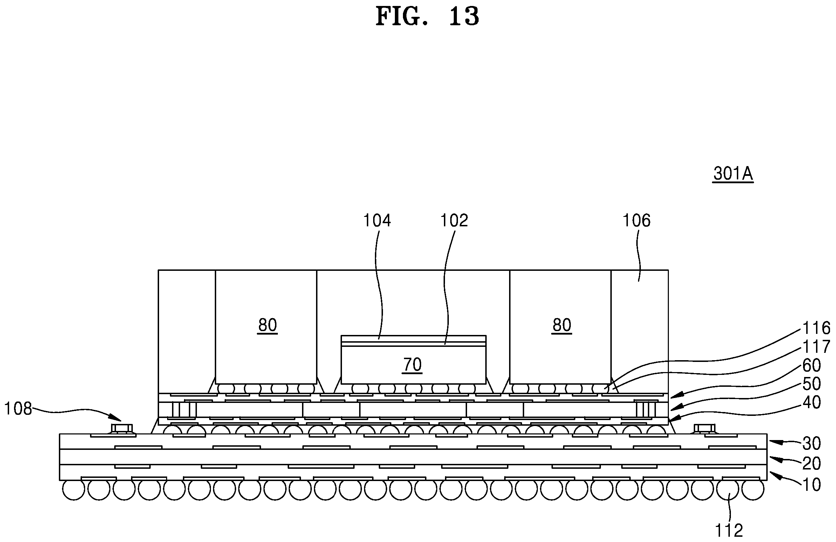

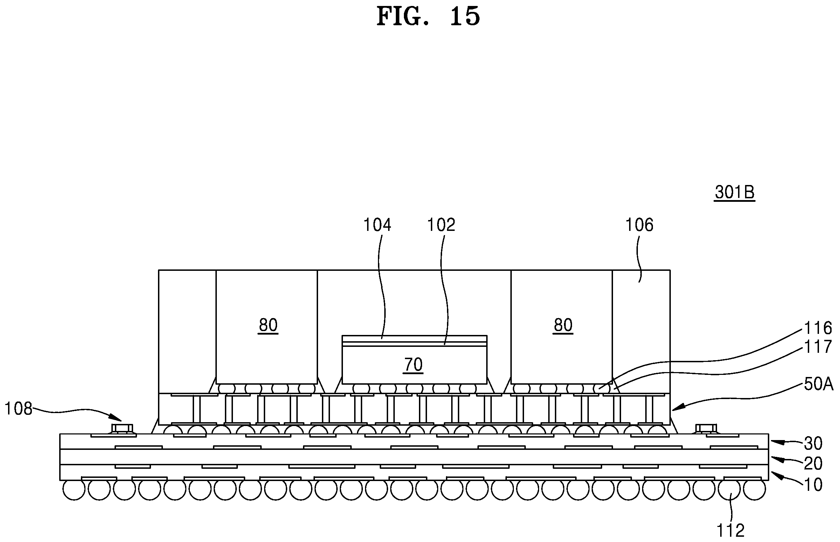

FIG. 12 illustrates a flowchart for the method of manufacturing a semiconductor device according to examples embodiments of the present disclosure. FIGS. 13-14 illustrate intermediate semiconductor devices formed in operations of the method, for explaining manufacturing of the semiconductor devices 1A-1C described above with reference to FIGS. 2A-4. FIGS. 15-16 illustrate intermediate semiconductor devices formed in operations of the method, for explaining manufacturing of the semiconductor devices 1D-1G described above with reference to FIGS. 5-8.

With reference to FIG. 12, the method may include providing an intermediate semiconductor device (operation 210), and providing at least one hybrid diamond thermal interposer on at least one semiconductor chip of the intermediate semiconductor device (operation 220). The method may further include attaching a stiffener ring to the intermediate semiconductor device (operation 230) or attaching a heat spreader to the intermediate semiconductor device (operation 240).

With reference to FIGS. 13 and 15, the operation 210 may include providing an intermediate semiconductor device (e.g., an intermediate semiconductor device 301A or an intermediate semiconductor device 301B). According to some embodiments of the present disclosure, the operation 210 may include manufacturing the intermediate semiconductor device (e.g., the intermediate semiconductor device 301A or the intermediate semiconductor device 301B).

For example, with reference to FIG. 13, the operation 210 may include forming, assembling together, and/or electrically connecting together any number of components of the intermediate semiconductor device including, for example, the first lower redistribution layer 10, the substrate 20, the first upper redistribution layer 30, the second lower redistribution layer 40, the interposer 50, the second upper redistribution layer 60, the first semiconductor chip 70, at least one second semiconductor chip 80, at least one metal pad 102, at least one first TIM 104, the semiconductor chip cap 108, bumps (e.g., the first bumps 112, the second bumps 114, the third bumps 116, and/or the third bumps 116A), underfill (e.g., the underfill 115 and/or the underfill 117), and/or molds (e.g., mold material 106). With reference to FIG. 15, the operation 220 may also include forming, assembling, and/or electrically connecting the interposer 50A, instead of the interposer 50. To form the semiconductor devices 1H-1J described above with reference to FIGS. 9-11, the intermediate semiconductor device provided through the operation 210 may not include, for example, the second semiconductor chips 80, the second lower redistribution layer 40, the interposer 50, and the second upper redistribution layer 60.

According to some example embodiments of the present disclosure, the operation 210 may include providing (e.g., sputtering) the metal pad 102 on at least one semiconductor chip (e.g., the first semiconductor chip 70 and/or the at least one second semiconductor chip 80), and providing the first TIM 104 on the at least one metal pad 102 that is on the at least one semiconductor chip (e.g., the first semiconductor chip 70 and/or the at least one second semiconductor chip 80).

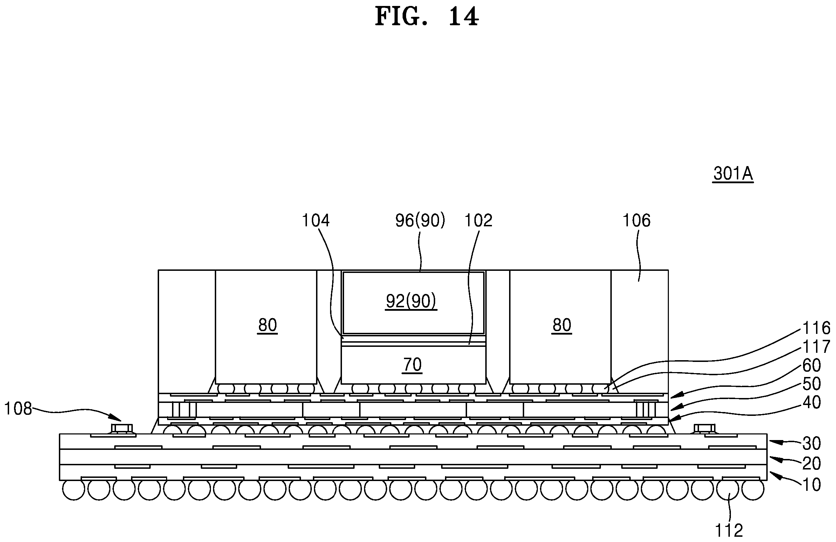

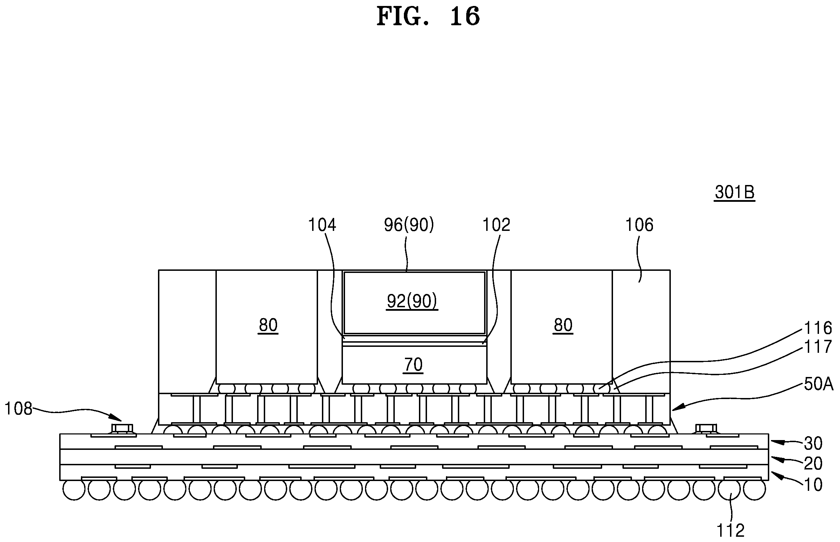

With reference to FIGS. 14 and 16, the operation 220 may include providing at least one hybrid diamond thermal interposer 90 on at least one semiconductor chip (e.g., the first semiconductor chip 70 and/or the at least one second semiconductor chip 80) of the intermediate semiconductor device. For example, the hybrid diamond thermal interposer 90 may be provided on the first semiconductor chip 70 with the metal pad 102 and the first TIM 104 therebetween. However, embodiments of the present disclosure are not limited thereto. For example, with reference to FIG. 4, a plurality of hybrid diamond thermal interposers 90 may be respectively provided on a plurality of semiconductor chips (e.g., the first semiconductor chip 70 and the at least one second semiconductor chip 80), with respective metal pads 102 and respective first TIMs 104 therebetween.

For example, the operation 220 may include attaching the at least one hybrid diamond thermal interposer 90 to the at least one semiconductor chip (e.g., the first semiconductor chip 70 and/or the at least one second semiconductor chip 80) by at least one metallic solder joint formed by the at least one metal pad 102 and the at least one first TIM 104.

With reference to FIGS. 2A, 5, 6A-B, and 9, the operation 230 may include attaching a stiffener ring (e.g., the stiffener ring 120 or the stiffener ring 120A) to the intermediate semiconductor device. For example, the stiffener ring (e.g., the stiffener ring 120 or the stiffener ring 120A) may be attached to the first upper redistribution layer 30 by an adhesive (e.g., the adhesive 122 or the adhesive 122A).

With reference to FIGS. 3-4, 7, 8A-B, and 10-11, the operation 230 may include attaching a heat spreader (e.g., the heat spreader 130, the heat spreader 130A, or the heat spreader 130B) to the intermediate semiconductor device. For example, the heat spreader (e.g., the heat spreader 130, the heat spreader 130A, or the heat spreader 130B) may be attached to the first upper redistribution layer 30 by an adhesive (e.g., the adhesive 122 or the adhesive 122A).

According to some example embodiments of the present disclosure, the operation 230 may further include attaching the heat spreader (e.g., the heat spreader 130, the heat spreader 130A, or the heat spreader 130B) onto the top surface(s) of the at least one the hybrid diamond thermal interposer 90 provided in the operation 220. For example, the operation 230 may further include attaching the heat spreader (e.g., the heat spreader 130, the heat spreader 130A, or the heat spreader 130B) onto the top surface(s) of the at least one hybrid diamond thermal interposer 90 by at least one second TIM 140 (or the second TIM 140A) that is on each of the hybrid diamond thermal interposers 90.

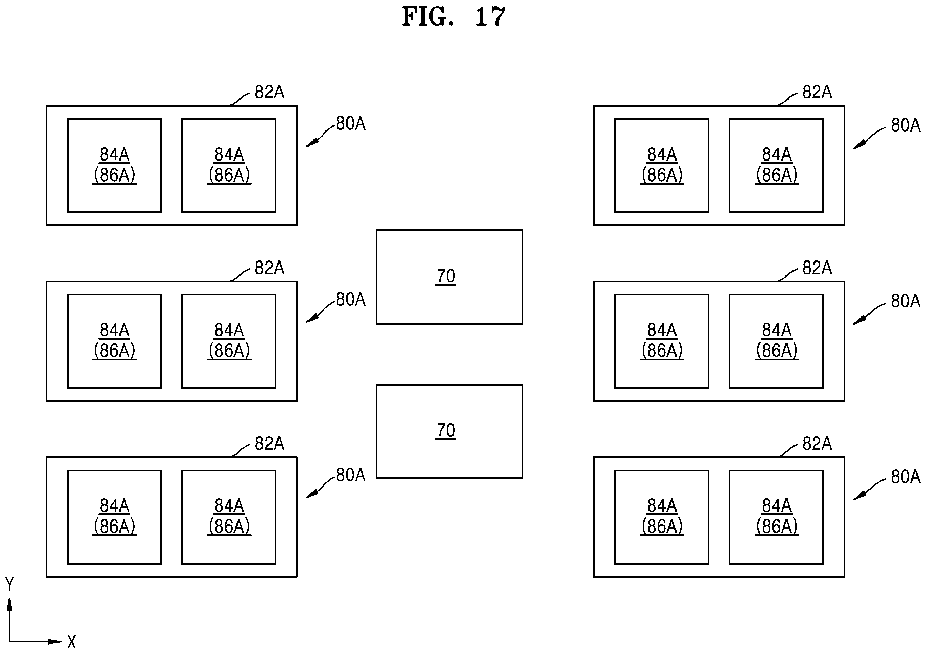

According to some example embodiments of the present disclosure, one or more (e.g., some or all) of the second semiconductor chips 80 may be a memory device 80A, and/or a plurality of the first semiconductor chips 70 may be provided. For example, the second semiconductor chips 80 of the example embodiments described above with reference to FIGS. 1-17 may be the memory devices 80A as described below with reference to FIG. 17. For example, an uppermost surface (e.g., an upper surface of uppermost ones of semiconductor chips 86A) of one or more (e.g., some or all) of the memory devices 80A may have thereon the metal pad 102, the first TIM 104, the hybrid diamond thermal interposer 90, the second TIM 140 (or the second TIM 140A), and/or a heat spreader (e.g., the heat spread 130, the heat spreader 130A, or the heat spreader 130B).

FIG. 17 illustrates a schematic plan view of first semiconductor chips 70 and the memory devices 80A of a semiconductor device according to example embodiments of the present disclosure. Example configurations of the memory devices 80A and the first semiconductor chips 70 are described below with reference to FIG. 17.

With reference to FIG. 17, one or more (e.g., some or all) of the memory devices 80A may include a bufferless logic die 82A and at least one stack 84A of a plurality of semiconductor chips 86A stacked on an upper surface of the bufferless logic die 82A in a vertical direction. Each stack 84A of the plurality of semiconductor chips 86A may be referred to as a "tower." According to some example embodiments of the present disclosure, each of the memory devices 80A may be an HBM, and each of the plurality of semiconductor chips 86A may be, for example, an HBM dual in-line memory module (DIMM).

As shown in FIG. 17, each of the memory devices 80A may include two stacks 84A of the semiconductor chips 86A on the bufferless logic die 82A. That is, one or more (e.g., some or all) of the memory devices 80A may be configured as a twin tower HBM that includes two towers of the semiconductor chips 86A. However, embodiments of the present disclosure are not limited thereto. For example, one or more (e.g., some or all) of the memory devices 80A may include only one stack 84A (or tower) of the semiconductor chips 86A or three or more stacks 84A (or towers) of the semiconductor chips 86A.

As shown in FIG. 17, for each of the memory devices 80A, the stacks 84A may be arranged with respect to each other and the first semiconductor chips 70 in an X-direction. However, embodiments of the present disclosure are not limited thereto. For example, for one or more (e.g., some or all) of the memory devices 80A, the stacks 84A may be arranged with respect to each other in any other horizontal direction (e.g., a Y-direction perpendicular to the X-direction) while being arranged with respect to the first semiconductor chips 70 in the X-direction. According to example embodiments, each of the memory devices 80A may be arranged at a same vertical level on the second upper redistribution layer 60 (see FIGS. 2-4) or the interposer 50A (see FIGS. 5-8).

As shown in FIG. 17, two first semiconductor chips 70 may be provided. However, embodiments of the present disclosure are not limited thereto. For example, only a single first semiconductor chip 70 may be provided or three or more of the first semiconductor chips 70 may be provided. As shown in FIG. 17, the plurality of first semiconductor chips 70 may be arranged with respect to each other in the Y-direction. However, embodiments of the present disclosure are not limited thereto. For example, one or more (e.g., some or all) of the first semiconductor chips 70 may be arranged with respect to each other any other horizontal direction (e.g., the X-direction). According to example embodiments, each of the first semiconductor chips 70 may be arranged at a same vertical level on the second upper redistribution layer 60 (see FIGS. 2-4) or the interposer 50A (see FIGS. 5-8).

According to some example embodiments of the present disclosure, an advanced package may be provided with improved thermal performance without sacrificing mechanical integrity of the advanced package.

According to some example embodiments of the present disclosure, a hybrid diamond thermal interposer integrated (e.g., the hybrid diamond thermal interposer 90) with a TIM (e.g., the first TIM 104 and/or the second TIM 140 (or the second TIM 140A)) with high thermal conductivity may be provided, thereby significantly improving thermal performance without sacrificing mechanical integrity of a package.

According to some example embodiments of the present disclosure, a semiconductor package (e.g., an advanced package) may be provided. The semiconductor package may include at least one semiconductor chip (e.g., the first semiconductor chip 70 and/or at least one second semiconductor chip 80); a heat sink, two thermal interface materials, and a thermal interposer (e.g., the hybrid diamond thermal interposer 90). The thermal interposer (e.g., the hybrid diamond thermal interposer 90) may be configured as a heat spreader and may include hybrid diamond (e.g., the hybrid diamond layer 92) that includes a metal matrix (e.g., metal matrix 95) in a diamond skeleton (e.g., the diamond skeleton 93) and may include no organic materials. The hybrid diamond (e.g., the hybrid diamond layer 92) may be coated with, for example, at least one layer (e.g., the outer layer 96 including, for example, nickel (Ni) and gold (Au) layers).

According to some example embodiments of the present disclosure, the semiconductor packages may be or include system-in-packages (SIPs), flip chip packages, advanced wafer-level and panel-level packages, and other high performance packages, requiring high thermal performance.

According to some example embodiments of the present disclosure, a semiconductor device having any package architecture requiring and having high thermal performance may be provided. The semiconductor device may include a hybrid diamond thermal interposer implemented in the package architecture.

According to some example embodiments of the present disclosure, a method (e.g., the method in Fig. 12) of manufacturing semiconductor devices (e.g., the semiconductor devices 1A-1J) may be provided.

According to some example embodiments of the present disclosure, a hybrid diamond thermal heat spreader (e.g., the hybrid diamond thermal interposer 90) may be provided and include Ag-diamond and/or Cu-diamond.

Furthermore, any element in a claim that does not explicitly state "means for" performing a specified function, or "step for" performing a specific function, is not to be interpreted as being limited to a "means" or "step" for performing the specified function. In particular, the use of "step of" or "act of" in the claims herein is not intended to invoke or be limited to the interpretation of performing the specified function as a "step" or "act" under such terminology.

The labels "left," "right," "front," "back," "top," "bottom," "forward," "reverse," "clockwise" and "counter clockwise," if used, have been used for convenience purposes only and are not intended to imply any particular fixed direction. Instead, they are used to reflect relative locations and/or directions between various portions of an object.

While embodiments have been described with respect to circuit functions, the embodiments of the present disclosure are not limited. Possible implementations may be embodied in a single integrated circuit, a multi-chip module, a single card, system-on-a-chip, or a multi-card circuit pack. As would be apparent to one skilled in the art, the various embodiments might also be implemented as part of a larger system. Such embodiments might be employed in conjunction with, for example, a digital signal processor, microcontroller, field-programmable gate array, application-specific integrated circuit, or general-purpose computer.

For the sake of brevity, conventional elements to semiconductor devices may or may not be described in detail herein. However, even if a certain element is described or illustrated in a semiconductor device in the present disclosure, the element may not be included in a claimed semiconductor device unless the element is recited as being included in the claimed semiconductor device. Also, when a particular method for deposition or etching used in manufacturing a semiconductor device (1) is or is not mentioned herein, it will be understood that a conventional method for such deposition or etching may be applied in corresponding steps of manufacturing the semiconductor device (1).

## Claims

1. A semiconductor device (1) comprising:
a substrate (20);
an interposer (50) at least partially on a first surface of the substrate (20) that faces in a first direction;
a first semiconductor chip (70) at least partially on a first surface of the interposer (50) that faces in the first direction;
a second semiconductor chip (80) at least partially on the first surface of the interposer (50), the second semiconductor chip (80) spaced apart from the first semiconductor chip (70) in a second direction that crosses the first direction; and
a hybrid diamond thermal interposer (90) at least partially on a first surface of the first semiconductor chip (70) that faces in the first direction or at least partially on a first surface of the second semiconductor chip (80) that faces in the first direction,
wherein the hybrid diamond thermal interposer (90) comprises diamond particles (94) within a metal.

2. The semiconductor device (1) of claim 1, wherein the first semiconductor chip (70) comprises a logic chip and the second semiconductor chip (80) comprises a memory chip, e.g. a high bandwidth memory, HBM.

3. The semiconductor device (1) of claim 1 or 2, wherein the hybrid diamond thermal interposer (90) is at least partially on the first surface of the first semiconductor chip (70).

4. The semiconductor device (1) of any one of the previous claims, wherein the hybrid diamond thermal interposer (90) is at least partially on the first surface of the second semiconductor chip (80).

5. The semiconductor device (1) of any one of the previous claims, wherein the hybrid diamond thermal interposer (90) is at least partially on the first surface of the first semiconductor chip (70),
wherein the semiconductor device (1) further comprises an additional hybrid diamond thermal interposer (92) at least partially on the first surface of the second semiconductor chip (80), and
wherein the additional hybrid diamond thermal interposer (92) comprises diamond particles (94) within a metal.

6. The semiconductor device (1) of any one of the previous claims, further comprising a first thermal interface material, TIM (104), between the hybrid diamond thermal interposer (90) and the first surface of the first semiconductor chip (70) or the first surface of the second semiconductor chip (80), and optionally the first TIM (104) comprises a solder material.

7. The semiconductor device (1) of claim 6, further comprising:
a metal pad (102) between the first TIM (104) and the first surface of the first semiconductor chip or the first surface of the second semiconductor chip (80).

8. The semiconductor device (1) of any one of the previous claims, further comprising:
a second TIM (140) at least partially on a first surface of the hybrid diamond thermal interposer (90) that faces in the first direction, and optionally the second TIM (140) comprises Ga, a Ga-In alloy, graphite, or a thermal grease.

9. The semiconductor device (1) of any one of the previous claims, further comprising:
a heat spreader (130) that is at least partially on the first surface of the substrate (20) and extends in the first direction and the second direction such as to overlap with the hybrid diamond thermal interposer (90) in the first direction.

10. The semiconductor device (1) of claim 8 and 9, wherein the heat spreader (130) is connected to the hybrid diamond thermal interposer (90) by the second TIM (140).

11. The semiconductor device (1) of claim 1, wherein:
the substrate (20) comprises a first organic substrate; and/or
the interposer (50) comprises a second organic interposer, e.g. a silicon interposer.

12. A method of manufacturing a semiconductor device (1), the method comprising:
providing (210) an intermediate semiconductor device (301) that comprises:
a substrate (20);
an interposer (50) at least partially on a first surface of the substrate (20) that faces in a first direction;
a first semiconductor chip (70) at least partially on a first surface of the interposer (50) that faces in the first direction; and
a second semiconductor chip (80) at least partially on the first surface of the interposer (50), the second semiconductor chip (80) spaced apart from the first semiconductor chip (70) in a second direction that crosses the first direction; and
providing (220) a hybrid diamond thermal interposer (90) at least partially on a first surface of the first semiconductor chip (70) that faces in the first direction or at least partially on a first surface of the second semiconductor chip (80) that faces in the first direction,
wherein the hybrid diamond thermal interposer (90) comprises diamond particles (94) within a metal.
